# EUROPÄISCHE PATENTSCHRIFT

(11) **EP 0 938 738 B1**
(45) Veröffentlichungstag und Bekanntmachung des Hinweises auf die Patenterteilung: **14.06.2000**
(21) Anmeldenummer: 97950134.3
(22) Anmeldetag: 06.11.1997
(51) Int. Cl.: H01H 59/00

(54) **VERFAHREN ZUM HERSTELLEN EINES MIKROMECHANISCHEN RELAIS**
METHOD FOR MANUFACTURING A MICROMECHANICAL RELAY
PROCEDE DE PRODUCTION D'UN RELAIS MICROMECANIQUE

(30) Priorität: 12.11.1996 DE 19646667; 17.07.1997 DE 19730715
(43) Veröffentlichungstag der Anmeldung: 01.09.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHIELE, Ignaz, D-85111 Adelschlag (DE); KOZLOWSKI, Frank, D-82284 Grafrath (DE)
(74) Vertreter: Schoppe, Fritz, Dipl.-Ing.
(86) Internationale Anmeldenummer: EP9706174
(87) Internationale Veröffentlichungsnummer: WO9821734

(56) Entgegenhaltungen:
- WO-A-91/05284
- DE-C- 4 437 260
- US-A- 5 510 156
- STORMENT C W ET AL: "FLEXIBLE, DRY-RELEASED PROCESS FOR ALUMINIUM ELECTROSTATIC ACTUATORS" JOURNAL OF MICROELECTROMECHANICAL SYSTEMS, Bd. 3, Nr. 3, September 1994, Seiten 90-96, XP000469763

## Beschreibung

Die vorliegende Erfindung bezieht sich auf Verfahren zum Herstellen eines mikromechanischen Relais.

Ein Relais dient grundsätzlich zum Schalten von elektrischen Strömen. Da das Schalten von elektrischen Strömen in der Technik häufig bewerkstelligt werden muß, gibt es ein großes Anwendungsgebiet für Relais. In neuerer Zeit wurden mikromechanische Relais entwickelt, die durch die Anwendung der Halbleitertechnologie auf einem neuen elektrostatischen Wirkprinzip basieren.

Dieses elektrostatische Wirkprinzip ermöglicht das fast leistungslose Schalten von Strömen. Diese Eigenschaft ist vor allem bei Anwendungen von Bedeutung, für die kein Anschluß an das Stromnetz möglich ist, also bei Anwendungen, deren Leistungsversorgung durch eine Batterie geliefert wird. Solche Anwendungen finden sich in zunehmendem Maße beispielsweise bei der drahtlosen Übermittlung in der Kommunikationstechnik. Um hier eine ausreichende Betriebsdauer zu gewährleisten, muß auf einen geringen Leistungsverbrauch geachtet werden. Dabei kann ein mikromechanisches Relais sinnvoll eingesetzt werden.

Ein zweites beispielhaftes Anwendungsfeld für ein mikromechanisches Relais ist das Schalten von Hochfrequenzsignalen. Ein solches Hochfrequenzrelais muß einen geringen Wellenwiderstand aufweisen, um beispielsweise in der HochfrequenzMeßtechnik eingesetzt werden zu können. Ein mikromechanisches Relais weist diese Eigenschaft auf, so daß gerade in der Hochfrequenztechnik ein derartiges Bauteil sehr große Vorteile bietet. Aus der DE 4205029 Cl und der DE 4437261 Cl sind beispielsweise elektrostatisch betätigte, mikromechanische Relais bekannt. Die elektrostatischen Kräfte werden jeweils nach dem gleichen Prinzip erzeugt. Zwischen zwei Kondensatorplatten wird eine Spannung angelegt. Eine mikromechanische Struktur als bewegliche Gegenelektrode ändert ihre Position relativ zu einer festen Elektrode aufgrund der elektrostatischen Kraft. Beim Anlegen einer Spannung an die Elektroden wird somit die bewegliche Gegenelektrode von der festen Elektrode angezogen.

Zur Herstellung des mikromechanischen Relais muß eine freistehende bewegliche Struktur erzeugt werden, die die Kontaktstücke trägt. Dies geschieht bei den bekannten Ausführungsformen durch einen Rückseitenätzprozeß. Dabei wird der Wafer von der Rückseite her in einem KOH-Ätzbad durchgeätzt, bis die Struktur freistehend ist. Aufgrund der spezifischen Ätzwinkel bei diesem Prozeß ist der Platzbedarf für eine Struktur wesentlich größer als die Struktur selbst. Somit ist bei dem bekannten Herstellungsverfahren für mikromechanische Relais der Flächenbedarf pro Bauteil bei der Herstellung wesentlich größer als der Flächenbedarf, den das fertige Bauteil schließlich besetzt.

Wurde nun gemäß den bekannten Verfahren eine bewegliche Struktur mittels eines Rückseitenätzprozesses freigelegt, so ist die Struktur zwar nun freistehend, wobei aber unter der freistehenden Struktur, d.h. dem beweglichen Balken, kein Substratmaterial mehr vorliegt, das als Elektrode dienen könnte. Somit muß zumindest ein zweiter Chip, der eine feststehende Elektrode aufweist, über dem prozessierten Chip angebracht werden, an dem nun eine Spannung angelegt werden kann. Das Verbinden der zwei Chips, das sogenannte Chipbonden, ist aber sehr aufwendig und schwierig.

Bei allen bekannten mikromechanischen Relais trägt der freistehende Balken die Kontaktstrukturen, eine Möglichkeit besteht darin, diese Kontaktstruktur längs auf dem Balken zu führen. Dies weist allerdings den Nachteil auf, daß diese Metallstruktur sehr dünn sein muß, um den Thermobimetalleffekt zwischen dem tragenden Balken und der Leiterbahn zu verringern. Es ist daher üblich, mikromechanische Relais mit einem doppelten Kontakt herzustellen, bei denen ein Kontaktbügel quer über die bewegliche Balkenspitze verläuft. Durch diese Anordnung ist die Verwölbung des Balkens aufgrund des Thermobimetalleffekts vermieden.

Aus der US-A-4959515 ist ein Verfahren zum Herstellen eines mikromechanischen Schalters bekannt, der einen einseitig eingespannten Hebelarm aufweist, dessen freies Ende durch elektrostatische Anziehung zum Schließen eines Kontakts verwendbar ist. Der einseitig eingespannte Hebelarm wird hergestellt, indem eine als Opferschicht verwendete Nickelschicht mittels einer starken Lösung vollständig geätzt wird.

In der EP-A-0711029 (nächstliegender Stand der Technik) ist die Herstellung einer Mikrostruktur mit einem beweglichen Arm durch das Wegätzen einer Haftmittelopferschicht unter dem beweglichen Arm beschrieben.

Ausgehend von dem genannten Stand der Technik besteht die Aufgabe der vorliegenden Erfindung darin, ein einfaches und platzsparendes Verfahren zum Herstellen eines mikromechanischen Relais zu schaffen.

Diese Aufgabe wird durch ein Verfahren gemäß Anspruch 1 gelöst.

Die vorliegende Erfindung schafft ein Verfahren zum Herstellen eines mikromechanischen Relais, das das Bereitstellen eines Substrats mit einer leitfähigen festen Elektrode in dem Substrat oder auf demselben umfaßt. Eine Opferschicht und eine leitfähige Schicht werden aufgebracht und die leitfähige Schicht wird zur Festlegung einer Balkenstruktur als bewegliche Gegenelektrode gegenüber der festen Elektrode strukturiert. Ein Kontaktbereich wird aufgebracht, wobei sich die leitfähige Schicht zwischen einem Verankerungsbereich und dem Kontaktbereich erstreckt und gegenüber dem Kontaktbereich isoliert ist. Nachfolgend wird die Opferschicht mittels Ätzen entfernt, um die Balkenstruktur mit einem beweglichen Bereich und einem an dem Verankerungsbereich an dem Substrat befestigten Bereich zu erzeugen. Die Balkenstruktur wird derart festgelegt, daß Ätzzugangsöffnungen in derselben derart strukturiert sind, daß die flächenmäßige Ausdehnung der Ätzzugangsöffnungen zum Ätzen der Opferschicht von dem an dem Substrat befestigen Bereich der Balkenstruktur zu dem beweglichen Bereich der Balkenstruktur hin zunimmt, so daß das Ätzen der Opferschicht derart gesteuert wird, daß der unter dem beweglichen Bereich der Balkenstruktur angeordnete Abschnitt der Opferschicht schneller geätzt wird als der im Bereich des Verankerungsbereichs angeordnete Abschnitt der Opferschicht.

Bei einem ersten bevorzugten Ausführungsbeispiel des erfindungsgemäßen Verfahrens werden zwei Kontakte in oder auf dem Substrat gebildet, wobei sich der gebildete Kontaktbereich zumindest zwischen den Kontakten und über denselben durch die Opferschicht beabstandet von denselben erstreckt.

Gemäß einem Ausführungsbeispiel wird die Opferschicht nach dem Aufbringen derselben strukturiert, um den Verankerungsbereich der Balkenstruktur gegenüber dem Substrat festzulegen.

Gemäß einem zweiten bevorzugten Ausführungsbeispiel des erfindungsgemäßen Verfahrens wird die Opferschicht derart geätzt, daß ein Teil der Opferschicht stehen bleibt, um eine Verankerungsschicht für den feststehenden Teil der Balkenstruktur für eine Verankerung an dem Substrat zu bilden. Bei diesem Ausführungsbeispiel können aus der leitfähigen Struktur ferner zwei auf der Opferschicht angeordnete Kontakte strukturiert werden, wobei die Opferschicht dann derart geätzt wird, daß ferner zwei Trägerbereiche der Opferschicht auf dem Substrat verbleiben, auf denen die Kontakte angeordnet sind.

Gemäß bekannten Fertigungsverfahren für Mikrorelais kommt meist ein Bulk-Mikromechanikprozeß zum Einsatz, bei dem ein Rückseitenätzschritt notwendig ist. Dies ist bei dem erfindungsgemäßen Relais nicht der Fall, da dasselbe mittels Techniken der Oberflächenmikromechanik gefertigt wird. Durch die Verwendung der Oberflächenmikromechanik ist das erfindungsgemäße Verfahren unabhängig vom Substratmaterial. Ferner kann dadurch die Bauteilgröße und die zur Herstellung benötigte Chipfläche kleingehalten werden.

Vorzugsweise wird zur Entfernung der Opferschicht ein Trockenätzprozeß verwendet. Dies ist möglich, indem als Opferschicht, die auch als Distanzschicht bezeichnet werden kann, ein organisches Opferschichtmaterial verwendet wird. Ein solches organisches Opferschichtmaterial ist beispielsweise Polyimid. Durch das Verwenden des Trockenätzens ist das Problem eines Anhaftens der beweglichen Balkenstruktur nach dem Ätzen an dem Substrat oder an einer Schicht, die auf das Substrat aufgebracht ist, vermieden. Die freigeätzten Strukturen werden nicht an das Substrat gezogen, sondern bleiben frei stehen.

Zur Funktion eines elektrostatisch betätigten mikromechanischen Relais ist es zwingend notwendig, daß sich Elektrode und Gegenelektrode in unmittelbarer Nähe befinden. Bei bisher bekannten Verfahren zum Herstellen eines mikromechanischen Relais wird dies durch das Bonden von zwei Chips erreicht. Gemäß der vorliegenden Erfindung ist dieses Bonden nicht notwendig, da das Substratmaterial während der Herstellungsschritte nicht entfernt wird. Das Relais wird also vollständig auf dem Wafer gefertigt, wobei nur die Oberfläche des Wafers prozessiert wird.

Um eine präzise Funktion eines mikromechanischen Relais zu gewährleisten, ist es vorteilhaft, die später freistehende Balkenstruktur mit einer Vorauslenkung zu beaufschlagen. Um eine hochgenaue Funktionsweise des mikromechanischen Relais sicherzustellen, muß diese Vorauslenkung der Balkenstruktur exakt kontrolliert werden können. Die vorliegende Erfindung schafft einen Schichtaufbau der Balkenstruktur, der es ermöglicht, beispielsweise durch die Wahl einer geeigneten Streifenbreite das Maß der Vorauslenkung genau einzustellen. Es ist daher nicht notwendig, Prozeßparameter oder Schichtdicken zu verändern, um einen anderen Spannungszustand in der Balkenstruktur zu erreichen. Dies ist gemäß der vorliegenden Erfindung sowohl für einseitig als auch für zweiseitig eingespannte Balken möglich.

Um die Kontaktfläche zwischen dem quer zu der beweglichen Balkenstruktur verlaufenden Kontaktbereich und den zwei mittels des Relais zu schaltenden Kontakten zu erhöhen, wird gemäß einem Ausführungsbeispiel der vorliegenden Erfindung auf dem quer zu der Balkenstruktur verlaufenden Kontaktbereich eine Schicht mit einer Druckspannung aufgebracht. Dadurch wird der Kontaktbereich nach unten ausgelenkt. Nach dem Anlegen einer Spannung zwischen der festen Elektrode und der beweglichen Gegenelektrode wird durch die elektrostatischen Kräfte der Balken so weit nach unten gezogen, bis der Kontaktbereich, der hierin als auch Kontaktbügel bezeichnet wird, fast plan auf den Kontakten auf dem Substrat aufliegt. Dadurch wird eine große Kontaktfläche erzeugt. Außerdem wird durch die in dem Kontaktbügel gespeicherte Energie das Öffnen des Relais zusätzlich beschleunigt.

Gemäß der vorliegenden Erfindung können einseitig eingespannte und zweiseitig eingespannte Balken als Gegenelektroden benutzt werden. Um eine Vorauslenkung für beide Varianten zu erreichen, sind eigentlich zwei unterschiedliche Spannungszustände notwendig. Durch einen geeigneten Schichtaufbau und eine geeignete Wahl der Ätzwinkel bei Strukturieren der leitfähigen Schicht zur Festlegung der Balkenstruktur ist es aber möglich, bei gleichen Prozeßschritten für beide Varianten eine Vorauslenkung zu erreichen. Um eine Querverwölbung der Balkenstruktur zu vermeiden, wird die Balkenstruktur vorzugsweise als eine Mehrzahl nebeneinander liegender Einzelbalken ausgebildet. Diese Einzelbalken werden vorzugsweise komplett durchgeätzt, wodurch die gesamte Balkenstruktur aus nebeneinander angeordneten langen Streifen besteht. Diese Ausgestaltung der Balkenstruktur unterstützt die Sicherstellung einer Vorauslenkung sowohl für eine einseitig eingespannte Balkenstruktur als auch eine zweiseitig eingespannte Balkenstruktur. Durch eine geeignete Wahl der Verfahrensschritte der vorliegenden Erfindung wird es möglich, die Vorauslenkung der Balkenstruktur durch eine geometrische Veränderung der Einzelbalken, beispielsweise eine Änderung der Breite der langen Streifen, zu steuern, während die Prozeßparameter konstant gehalten werden können.

Bezüglich des oben beschriebenen Anhaftens (Sticking) kann zwischen zwei Varianten unterschieden werden. Zum einen kann ein Anhaften während der Herstellung eines elektrostatisch betätigten mikromechanischen Relais auftreten und zum anderen während des Betriebs desselben. Wie oben beschrieben wird eine sogenannte Opferschicht verwendet, die mittels Ätzens entfernt wird, um die Balkenstruktur mit einem beweglichen Bereich zu erzeugen. Wird die Opferschicht in einem naßchemischen Prozess entfernt, kommt es häufig zu einer Anhaftung, da durch die Adhäsionskräfte der trocknenden Flüssigkeit die Struktur zum Substrat hingezogen wird, wo sie dann haften bleibt. Gemäß der vorliegenden Erfindung wird jedoch eine Opferschicht verwendet, die durch einen Trockenätzprozess entfernt werden kann, so daß dieses Problem umgangen wird und folglich nicht auftritt.

Bei einem Mikrorelais der beschriebenen Art wird eine bewegliche Balkenstruktur durch elektrostatische Kräfte zu einem Substrat gezogen, auf dem sie dann ganzflächig aufliegt. Wird die Spannungsversorgung unterbrochen, bewegt sich der Balken aufgrund der wirkenden elastischen Rückstellkräfte wieder in seine Ausgangsposition zurück. Es ist jedoch möglich, daß die Strukturen während des Betriebs derart stark zum Substrat ausgelenkt werden, daß die adhäsiven Kräfte zwischen den Festkörperoberflächen, beispielsweise die Coulomb-Kraft und die Van-der-Waals-Kraft, stärker werden als die aufgrund der Durchsenkung des Balkens wirkenden elastischen Rückstellkräfte. Dadurch kann es zum dauerhaften Anhaften der Strukuren auf dem Substrat kommen. Ebenso können die Rückstellkräfte des Balkens während der Lebensdauer aufgrund einer Materialermüdung nachlassen, so daß dadurch bedingt ein dauerhaftes Anhaften der Struktur an dem Substrat auftritt.

Ein weiterer Vorteil der vorliegenden Erfindung besteht darin, daß bei einem mittels des erfindungsgemäßen Verfahrens hergestellten mikromechanischen Relais ein Anhaften der beweglichen Elektrode an der festen Elektrode im Betrieb des Relais verhindert werden kann, indem die leitfähige feste Elektrode bei dem Schritt des Bereitstellens eines Substrats mit einer leitfähigen festen Elektrode in dem Substrat oder auf demselben mit einer solchen Oberflächenbeschaffenheit ausgebildet wird, daß beim späteren Betrieb des mikromechanischen Relais eine Berührungsfläche der festen Elektrode mit der beweglichen Gegenelektrode gegenüber der Berührungsfläche einer im wesentlichen flachen Oberfläche der festen Elektrode reduziert ist.

Zu diesem Zweck kann die leitfähige feste Elektrode beispielsweise durch eine galvanische Abscheidung erzeugt und nachfolgend zur Aufrauhung der Oberfläche derselben angeätzt werden. Ferner kann die leitfähige feste Elektrode durch das galvanische Abscheiden einer Schicht erzeugt werden, wobei die Schicht nachfolgend strukturiert wird, um Erhebungen und Vertiefungen in derselben zu bilden. Eine weitere Möglichkeit besteht darin, als Substrat einkristallines Silizium zu verwenden, in dessen Oberflächenbereich, in oder auf dem die feste Elektrode gebildet werden soll, naßchemisch pyramidenförmige Strukturen geätzt werden.

Weiterbildungen der vorliegenden Erfindung sind in den abhängigen Ansprüchen definiert.

Bevorzugte Ausführungsbeispiele der vorliegenden Erfindung werden nachfolgend bezugnehmend auf die beiliegenden Zeichnungen näher erläutert. Es zeigen:
- Fig. 1: eine Seitenschnittansicht des Schichtaufbaus gemäß einem bevorzugten Ausführungsbeispiel des erfindungsgemäßen Herstellungsverfahrens;
- Fig. 2: eine Vorderschnittansicht entlang der Linie II-II von Fig. 1;
- Fig. 3: schematisch eine Draufsicht einer einseitig eingespannten Balkenstruktur mit Verankerungsbereich und Kontaktbügel;
- Fig. 4: schematisch eine Seitenschnittansicht eines mittels des erfindungsgemäßen Verfahrens hergestellten mikromechanischen Relais mit einseitig eingespannter Balkenstruktur;
- Fig. 5: schematisch eine Draufsicht einer zweiseitig eingespannten Balkenstruktur mit Kontaktbügeln und zwei Verankerungsteilbereichen;
- Fig. 6 bis 8: schematische Draufsichten unterschiedlich ausgestalteter einseitig eingespannter Balkenstrukturen jeweils mit Kontaktbügel und Verankerungsbereich;
- Fig. 9a: eine Schnittansicht des Schichtaufbaus und des Ätzwinkels eines Einzelbalkens der Balkenstruktur gemäß einem Ausführungsbeispiel der vorliegenden Erfindung;
- Fig. 9b: die Spannungszustände in dem in Fig. 9a dargestellten Schichtaufbau;
- Fig. 10a und 10b: Seitenschnittansichten zur Veranschaulichung eines weiteren Ausführungsbeispiels des erfindungsgemäßen Verfahrens;
- Fig. 11 und 12: eine Seitenschnittansicht bzw. eine Vorderschnittansicht entlang der Linie XII-XII von Fig. 11 eines mittels eines weiteren Ausführungsbeispiels des erfindungsgemäßen Verfahrens hergestellten mikromechanischen Relais;
- Fig. 13: eine alternative Ausführungsform eines mikromechanischen Relais, wobei die Oberfläche der festen Elektrode desselben der Oberfläche des in den Fig. 11 und 12 dargestellten mikromechanischen Relais entspricht;
- Fig. 14 und 15: eine Seitenschnittansicht bzw. eine Vorderschnittansicht entlang der Linie XV-XV von Fig. 14 eines mittels eines weiteren Ausführungsbeispiels des erfindungsgemäßen Verfahrens hergestellten mikromechanischen Relais;
- Fig. 16: eine Ausführungsform eines mikromechanischen Relais, dessen feste Elektrode eine Oberfläche aufweist, die der Oberfläche der festen Elektrode des mikromechanischen Relais, das in den Fig. 14 und 15 gezeigt ist, entspricht;
- Fig. 17 und 18: eine Seitenschnittansicht bzw. eine Vorderschnittansicht entlang der Linie XVIII-XVIII von Fig. 17 eines mittels des erfindungsgemäßen Verfahrens hergestellten mikromechanischen Relais; und
- Fig. 19: eine alternative Ausführungsform eines mikromechanischen Relais, dessen feste Elektrode eine Oberfläche aufweist, die der Oberfläche der festen Elektrode des in den Fig. 17 und 18 dargestellten mikromechanischen Relais entspricht.

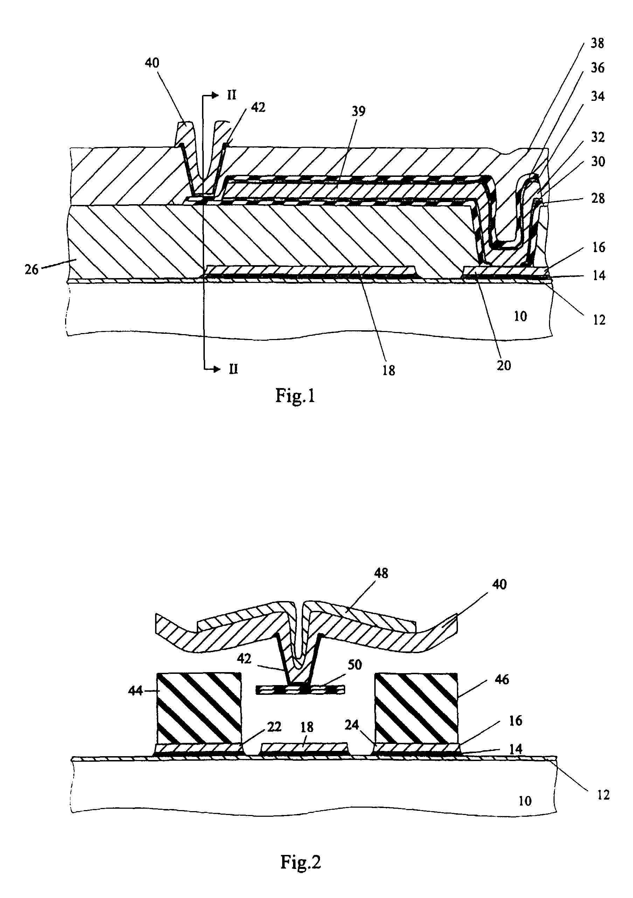

Im folgenden wird nun anhand der Fig. 1 und 2 ein erstes bevorzugtes Ausführungsbeispiel des Herstellungsverfahrens gemäß der vorliegenden Erfindung näher erläutert.

In Fig. 1 sind alle Schichten dargestellt, die zur Herstellung eines mikromechanischen Relais gemäß dem bevorzugten Ausführungsbeispiel der vorliegenden Erfindung benötigt werden. Es ist jedoch für Fachleute offensichtlich, daß das erfindungsgemäße Verfahren nicht alle im folgenden gemäß Fig. 1 beschriebenen Verfahrensschritte aufweisen muß, wobei ferner alternative Materialien verwendet werden können.

Als Basismaterial wird zunächst ein Substrat 10, das bei dem bevorzugten Ausführungsbeispiel ein Siliziumwafer ist, bereitgestellt. Auf das Substrat 10 wird nachfolgend eine Isolationsschicht 12 aufgebracht, die bei dem bevorzugten Ausführungsbeispiel aus SiO₂ besteht. Anschließend wird eine Haftschicht 14 auf der Isolationsschicht 12 abgeschieden, woraufhin eine leitfähige Schicht 16 auf der Haftschicht 14 abgeschieden wird. Die Haftschicht 14 dient dazu, die Haftung zwischen der Isolationsschicht 12 und der leitfähigen Schicht 16 zu verbessern. Die Haftschicht 14 besteht bei dem bevorzugten Ausführungsbeispiel aus NiCr. Alternativ könnte die Haftschicht aus TiW bestehen. Die leitfähige Schicht besteht bei dem bevorzugten Ausführungsbeispiel aus Gold (Au). Alternativ könnte die leitfähige Schicht 16 aus einem beliebigen Metall, vorzugsweise einem edlen Metall bestehen. Die Goldschicht 16 und die NiCr-Schicht 14 werden bei dem bevorzugten Ausführungsbeispiel nachfolgend mittels eines photolithographischen Verfahrens strukturiert, um eine feststehende Elektrode 18, einen Verankerungskontaktbereich 20 sowie einen ersten Kontakt 22 und einen zweiten Kontakt 24 (siehe Fig. 2) festzulegen.

Statt des oben beschriebenen Verfahrens zum Herstellen der feststehenden Elektrode, des Verankerungskontaktbereichs, sowie des ersten und des zweiten Kontakts, könnten diese Bereiche auch durch eine geeignete Dotierung in dem Substrats 10 erzeugt werden.

Nachfolgend wird auf die nun vorliegende Struktur eine Opferschicht oder Distanzschicht 26 aufgebracht, die bei dem bevorzugten Ausführungsbeispiel aus Polyimid besteht. Diese Opferschicht 26 wird bei dem ersten bevorzugten Ausführungsbeispiel, beispielsweise photolithographisch, strukturiert, um einen Verankerungsbereich, der bei dem bevorzugten Ausführungsbeispiel durch den Verankerungskontaktbereich 20 definiert ist, festzulegen.

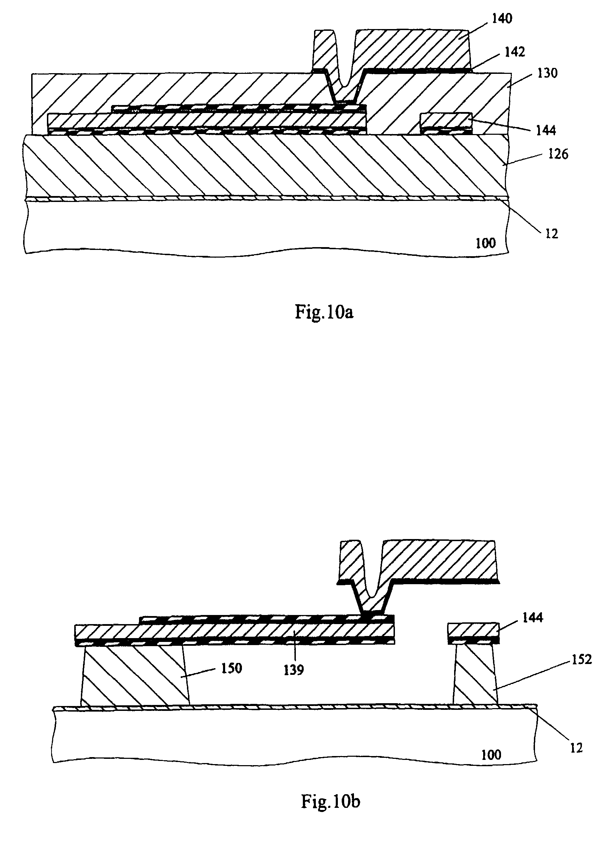

Ein weiteres bevorzugtes Ausführungsbeispiel des erfindungsgemäßen Verfahrens, bei dem ein Teil der Opferschicht als Verankerungsschicht verwendet wird, wird später bezugnehmend auf die Fig. 10a und 10b erläutert.

Im Anschluß wird bei dem ersten bevorzugten Ausführungsbeispiel ein Schichtverbund bestehend aus einer ersten Passivierungsschicht 28, einer ersten Haftschicht 30, einer leitfähigen Schicht 32, einer zweiten Haftschicht 34 und einer zweiten Passivierungsschicht 36 aufgebracht. Die Materialien dieser Schichten 28 bis 36 sind bei dem bevorzugten Ausführungsbeispiel derart gewählt, daß sich ein SiO₂-NiCr-Au-NiCr-SiO₂-Schichtverbund ergibt. Dieser Schichtverbund stellt die Grundlage für die spätere bewegliche Gegenelektrode dar.

Der Schichtverbund bestehend aus den Schichten 28, 30, 32, 34, 36 wird strukturiert, um eine Balkenstruktur, die später als bewegliche Gegenelektrode 39 gegenüber der festen Elektrode 18 dienen soll, festzulegen. Die Ausgestaltung dieser Balkenstruktur wird nachfolgend näher erläutert. Die Elektrodenstruktur ist bei diesem Ausführungsbeispiel über den Verankerungskontaktbereich 20 fest mit dem Substrat 10 verbunden. Alternativ könnte die Elektrodenstruktur bei diesem Ausführungsbeispiel ohne den Verankerungskontaktbereich 20 fest mit dem Substrat 10 verbunden sein. An dem anderen Ende ist die Elektrodenstruktur durch die Opferschicht 26 von dem Substrat beabstandet.

Nachfolgend wird auf die gebildete Struktur ein Photolack 38 aufgebracht. Der Photolack 38 wird strukturiert, um eine Maske zum Aufbringen eines Kontaktbügels 40 zu bilden. Bei den bevorzugten Ausführungsbeispielen der vorliegenden Erfindung besteht der Kontaktbügel 40 aus Gold und ist über die Passivierungsschichten 28 und 36 isoliert an dem später beweglichen Ende der Balkenstruktur angebracht. Ferner ist bei dem bevorzugten Ausführungsbeispiel unter dem Kontaktbügel 40 wiederum eine Haftschicht 42, die aus NiCr besteht, angeordnet.

Es ist offensichtlich, daß die Bildung und Strukturierung der leitfähigen Schicht und des Kontaktbereichs auf eine von der oben beschriebenen abweichende Art und Weise gebildet werden kann.

Anschließend wird die Opferschicht 26, die bei dem bevorzugten Ausführungsbeispiel aus Polyimid besteht, in einem Trockenätzprozeß entfernt. Dabei ist es, um ein sicheres Freiätzen der Balkenstruktur zu gewährleisten, sinnvoll, wenn zuerst die Spitze des Balkens bei der in Fig. 1 dargestellten einseitig aufgehängten Balkenstruktur freigeätzt wird und die Ätzfront dann nach und nach zum eingespannten Ende des Balkens hin verläuft. Bei einem derartigen Ätzen wölbt sich der Balken durch den gewählten Schichtaufbau immer mehr nach oben, so daß kein Anhaften des Balkens an dem Substrat auftreten kann.

Alternativ wird bei einem Herstellungsverfahren für eine zweiseitig eingespannte Balkenstruktur die Polyimidschicht von der Mitte der Struktur her zu den jeweiligen Verankerungsteilbereichen hin weggeätzt. Wie nachfolgend detaillierter erläutert wird, wird die Ätzfront dadurch gesteuert, daß in dem beweglichen Bereich der Balkenstruktur die Ätzangriffsfläche vergrößert ist.

Fig. 2 zeigt eine Schnittansicht entlang der Linie II-II von Fig. 1. Wie in Fig. 2 dargestellt ist, sind der erste und der zweite Kontakt 22 und 24 bei dem bevorzugten Ausführungsbeispiel mit Kontakthöckern 44 bzw. 46 versehen, um beim Schließen des Relais eine Kontaktierung mit dem Kontaktbügel 40 zu erleichtern.

Da die Goldschicht des Kontaktbügels 40 unter Zugspannung steht, würde dies zu einer Verformung nach oben führen. Um eine solche Auslenkung zu verhindern, ist bei dem bevorzugten Ausführungsbeispiel eine TiW-Schicht 48 auf die Goldschicht aufgebracht. Die TiW-Schicht steht unter Druckspannung. Ist diese Druckspannung größer als die resultierende Zugspannung der Goldschicht, wird der Kontaktbügel nach unten verformt. Um eine optimale Kontaktfläche des Kontaktbügels 40 mit den Kontakthöckern 44 und 46 zu erhalten, ist es notwendig, daß der Kontaktbügel 40 an einer bestimmten Stelle und zwar in der Mitte der Kontakthöcker 44 und 46 wieder nach oben verformt. Beim Schließen des Relais legt sich dann der Kontaktbügel 40 an die Kontakthöcker 44 und 46 an und liegt fast plan auf, so daß die Kontaktfläche groß wird. Dies wird erreicht, indem an diesen Stellen die TiW-Schicht 48 auf dem Kontaktbügel 40 entfernt wird, so daß durch die Zugspannung in der Goldschicht der Kontaktbügel wieder nach oben ausgelenkt wird. An der Unterseite des Kontaktbügels 40 ist eine Isolationsschicht 50 angebracht, um eine mögliche Kontaktierung des Kontaktbügels 40 mit der feststehenden Elektrode 18 zu verhindern.

Wird nun durch Anlegen einer Spannung zwischen den beiden Elektroden, d.h. der feststehenden Elektrode 18 und der beweglichen Elektrode 39, ein elektrisches Feld zwischen denselben aufgebaut, so entsteht eine elektrostatische Kraft, die den Balken zu dem Substrat hin anzieht, so daß der Kontaktbügel 40 eine leitfähige Verbindung zwischen den Kontakthöckern 44 und 46 herstellt. Wird die Spannung wieder unterbrochen, wirkt keine elektrostatische Kraft mehr und die Gegenelektrode 39 geht aufgrund der Rückstellkraft des Balkens wieder in die Ausgangslage zurück. Dadurch wird die leitfähige Verbindung zwischen den Kontakthöckern 44 und 46, die durch den Kontaktbügel 40 gebildet wurde, wieder gelöst.

Die genannte Rückstellkraft ist bei einem beidseitig eingespannten Balken größer als bei einem einseitig eingespannten Balken.

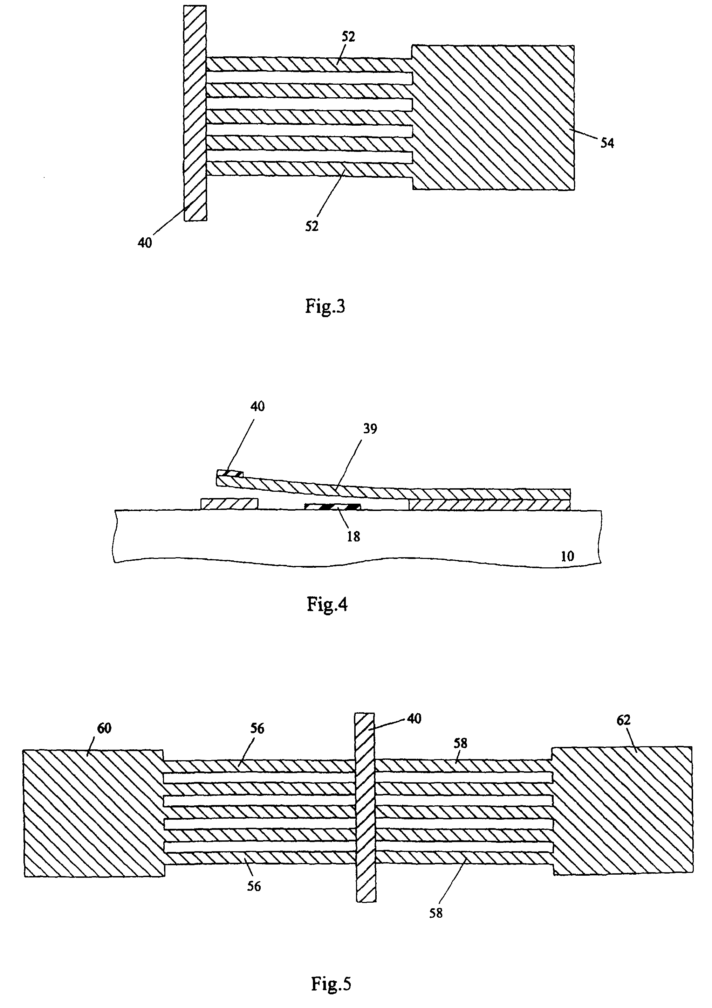

In Fig. 3 ist eine schematische Draufsicht einer Balkenstruktur mit Verankerungsbereich und Kontaktbügel dargestellt. Die Balkenstruktur ist als eine Mehrzahl von Einzelbalken 52 strukturiert. An dem beweglichen Ende der Einzelbalken 52 ist isoliert quer zum Verlauf der Einzelbalken 52 der Kontaktbügel 40 angeordnet. Die Einzelbalken 52 sind in einem Verankerungsbereich 54 an dem Substrat befestigt. Somit ergibt sich eine einseitig, am Verankerungsbereich 54 eingespannte Balkenstruktur, an deren beweglichem Ende der Kontaktbügel 40 angeordnet ist. Die Balkenstruktur ist bei diesem Ausführungsbeispiel als nebeneinander angeordnete Einzelbalken 52 ausgebildet, um eine Querverwölbung der freistehenden Strukturen zu vermeiden.

In Fig. 4 ist eine schematische Seitenschnittansicht eines einseitig eingespannten mikromechanischen Relais dargestellt. Beim Anlegen einer Spannung zwischen den Elektroden 18 und 39 wird das bewegliche, vorgespannte Ende der Balkenstruktur zu dem Substrat 10 hingezogen, woraufhin der Kontaktbügel 40 auf dem Substrat angeordnete Kontakthöcker leitend miteinander verbindet.

In Fig. 5 ist eine schematische Draufsicht einer zweiseitig eingespannten Balkenstruktur dargestellt. Wiederum besteht die Balkenstruktur aus Einzelbalken 56 bzw. 58, die jeweils an einem Verankerungsteilbereich 60 bzw. 62 an einem Substrat befestigt sind. Der Kontaktbügel 40 ist bei der zweiseitig eingespannten Balkenstruktur in der Mitte der Balken angeordnet.

Zur erfindungsgemäßen Herstellung eines Mikrorelais mittels der Oberflächenmikromechanik werden die Technologien der hochintegrierten Schaltungen verwendet. Das bedeutet, daß nur Planartechniken eingesetzt werden. Auf einem Basismaterial, einem Wafer, werden also Schichten ganzflächig abgeschieden und strukturiert. Durch öfteres Wiederholen dieses Vorganges entsteht der nötige Schichtaufbau.

Um zwischen zwei Schichten, die durch eine Distanzschicht voneinander getrennt sind, eine Spannung anlegen zu können, müssen diese Schichten über eine gewisse elektrische Leitfähigkeit verfügen. Daher werden für diese Schichten Metalle verwendet. Um bei Berührung dieser Schichten, die Elektroden darstellen, einen Kurzschluß zu vermeiden, muß zumindest eine dieser Metallschichten isoliert sein. Bei dem oben beschriebenen bevorzugten Ausführungsbeispiel geschieht dies durch die zwei Passivierungsschichten 28 und 36, die auf der Unterseite und der Oberseite der beweglichen Elektrode abgeschieden werden. Somit ist die bewegliche Elektrode komplett isoliert. Alternativ könnte eine Isolationsschicht auch auf der feststehenden Elektrode 18 abgeschieden werden. Um die Haftung einer derartigen Passivierungsschicht auf einer Metallschicht zu verbessern, ist es vorteilhaft, eine Zwischenschicht aufzubringen, die bei dem bevorzugten Ausführungsbeispiel aus NiCr besteht. Alternativ könnte wie erwähnt beispielsweise auch TiW als Material für die Haftschicht verwendet werden.

Als Material für die kontaktbildenden Strukturen, d.h. die Kontakthöcker 44 und 46 sowie den Kontaktbügel 40, wird vorzugsweise ein edles Metall verwendet, da ein solcher Werkstoff den Anforderungen an Kontaktwiderstand, Abbrand und Schweißverhalten genügen kann.

Bei dem erfindungsgemäßen Verfahren zur Herstellung des mikromechanischen Relais ist es nötig, die Opfer- oder Distanz-Schicht 26 zwischen den beiden Elektroden 18 und 39 zu beseitigen. Um das Klebenbleiben der beweglichen Elektrode 39, d.h. der Balkenstruktur, am Substrat zu verhindern, wird diese Schicht vorzugsweise in einem Trockenätzprozeß entfernt. Bei einem solchen Trockenätzprozeß kann es zu Inhomogenitäten kommen, d.h. die Opferschicht kann an einigen Stellen schneller und an anderen Stellen langsamer entfernt werden. Dadurch verstärkt sich wiederum die Gefahr des Anhaftens der Balkenstruktur an dem Substrat, da sich der Balken durch unregelmäßiges Freiätzen anfangs bereits so verwölben kann, daß es nach dem Entfernen der Opferschicht zu einem Anhaften kommt.

Das oben beschriebene Anhaften kann durch ein Ausführungsbeispiel des erfindungsgemäßen Verfahrens verhindert werden, indem sichergestellt wird, daß zu Anfang die Balkenspitze freigeätzt wird und dann nach und nach zum am Substrat befestigten Balkenende hin die Opferschicht entfernt wird. Um den Ätzvorgang in einem definierten Maße zu steuern, müssen die Ätzzugangslöcher, die das Ätzen der Opferschicht ermöglichen, in einer bestimmten Weise angeordnet werden.

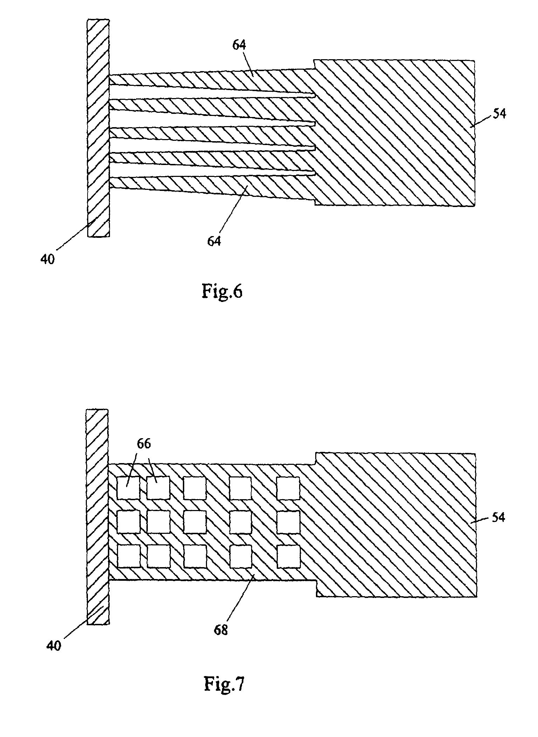

Fig. 6 zeigt eine schematische Draufsicht einer einseitig eingespannten Balkenstruktur mit Verankerungsbereich 54 und Kontaktbügel 40. Die Balkenstruktur weist wiederum eine Mehrzahl von Einzelbalken 64 auf. Allerdings sind bei dem in Fig. 6 dargestellten Ausführungsbeispiel die Einzelbalken keilförmig geformt. Im Bereich des Verankerungsbereichs 54 sind die Einzelbalken 64 breiter, während sie zu dem beweglichen Ende der Balkenstruktur, an dem der Kontaktbügel 40 angebracht ist, hin zunehmend schmäler werden. Dadurch sind die Ätzzugangsöffnungen, die durch die Zwischenräume zwischen den Einzelbalken 64 gebildet sind, am freien Ende der Balkenstruktur groß und nehmen zu dem Verankerungsbereich hin ab, wodurch die Ätzfront gesteuert werden kann, derart, daß zunächst im Bereich des beweglichen Endes der Balkenstruktur die Opferschicht schneller entfernt wird.

In Fig. 7 ist eine Balkenstruktur dargestellt, bei der eine Mehrzahl von Ätzzugangsöffnungen 66 in einer Balkenstruktur, die aus einem einzelnen Balken 68 gebildet ist, angeordnet sind. Die Ätzzugangsöffnungen 66 sind im beweglichen Bereich der Balkenstruktur näher beieinander angeordnet, um dadurch die Ätzzugangsöffnungsfläche in diesem Bereich gegenüber den Bereichen in der Nähe des Verankerungsbereichs 54 zu erhöhen. Auch hierdurch wird ein schnelleres Ätzen im Bereich des beweglichen Endes als in der Nähe des Verankerungsbereichs 54 erreicht, um ein Anhaften zu verhindern.

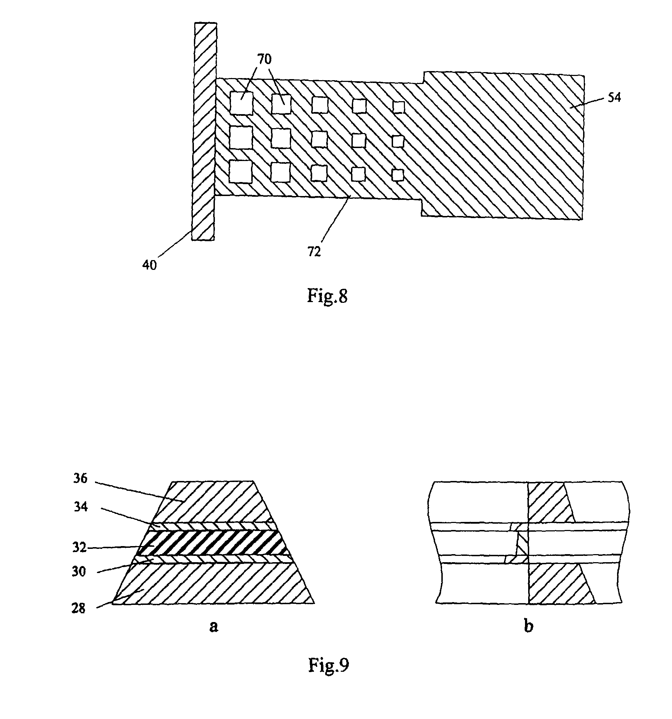

In Fig. 8 ist ein ähnliches Ausführungsbeispiel dargestellt, bei dem wiederum eine Mehrzahl von Ätzzugangsöffnungen 70 in einer Balkenstruktur, die aus einem einzelnen Balken 72 gebildet ist, angeordnet sind. Die Größe der Ätzzugangsöffnungen 70 nimmt von dem beweglichen Ende der Balkenstruktur zu dem Verankerungsbereich 54 hin ab. Wiederum wird dadurch ein gesteuertes Ätzen ermöglicht.

Die oben beschriebenen unterschiedlichen Geometrien der Balkenstruktur dienen alle dazu, ein sicheres Freiätzen der beweglichen Elektroden zu garantieren und die Gefahr des Anhaftens zu minimieren. Die Ätzfront wird natürlich auch dadurch gesteuert, daß die zu unterätzende Fläche bei den dargestellten Geometrien im Bereich des beweglichen Balkenendes kleiner ist als im Bereich zu dem an dem Substrat befestigten Balkenende hin. Das bedeutet, daß die Opferschicht im Bereich des beweglichen Balkenstrukturendes schneller abgetragen werden kann, so daß ein definiertes Freiätzen möglich wird.

Der gemäß dem bevorzugten Ausführungsbeispiel der vorliegenden Erfindung verwendete Trockenätzprozeß ist bezüglich des Anhaftens gegenüber einem Naßätzprozeß vorteilhaft. Bei einem naßchemischen Ätzprozeß wird meist durch die Adhäsionskräfte der trocknenden Flüssigkeit die bewegliche Struktur zum Substrat hingezogen, wo sie dann anhaftet. Folglich ist es vorteilhaft, als Opferschichtmaterial ein solches Material zu wählen, das in einem Trockenätzprozeß entfernbar ist. Vorteilhaft kann hierbei ein organisches Material, bei dem bevorzugten Ausführungsbeispiel der vorliegenden Erfindung Polyimid, verwendet werden. Da eine derartige Schicht normalerweise nur eine geringe Temperaturbeständigkeit aufweist, müssen die nachfolgenden Prozeßschritte diesen Anforderungen angepaßt werden, dies ist bei dem erfindungsgemäßen Verfahren zum Herstellen eines mikromechanischen Relais der Fall.

Bei der Herstellung eins mikromechanischen Relais ist es nötig, unterschiedliche Schichten übereinander aufzubringen. Diese Schichten sind normalerweise spannungsbehaftet. Das bedeutet, daß jede Schicht eine eingeprägte Druck- oder Zugspannung aufweist. Welche Art von Spannung eine jeweilige Schicht aufweist, hängt von dem Schichtmaterial und von dem Prozeßparametern ab. Bei dem erfindungsgemäßen Verfahren zur Herstellung eines mikromechanischen Relais kann diese Eigenschaft ausgenutzt werden, indem in definiertem Maße ein Spannungszustand in der frei beweglichen Struktur erzeugt wird. Dadurch kann eine Vorauslenkung des Balkens bewirkt werden, so daß nach dem Schließen des Balkens eine noch größere Menge an Energie in dem Balken gespeichert werden kann. Diese zusätzliche Energie kann vorteilhaft genutzt werden, um das Öffnen der Kontakte, d.h. das Lösen des Kontaktbügels 40 von den Kontakthöckern 44 und 46, schnell bewerkstelligen zu können. Beim Betrieb eines Mikrorelais ist ein derartiges schnelles Öffnen und Schließen der Kontakte vorteilhaft.

Bei dem bevorzugten Ausführungsbeispiel werden die Passivierungsschichten 28 und 36 zum Definieren einer eingeprägten definierten Eigenspannung der Balkenstruktur verwendet. In Fig. 9a ist ein Schnitt durch einen Einzelbalken einer aus mehreren Einzelbalken bestehenden Balkenstruktur dargestellt. Der Schichtaufbau der zwei Passivierungsschichten 28 und 36, der zwei Haftschichten 30 und 34 sowie der leitfähigen Schicht 32 entspricht dem Schichtaufbau bei dem oben bezugnehmend auf Fig. 1 beschriebenen bevorzugten Ausführungsbeispiel.

Dieser Schichtverbund hat zur Folge, daß sowohl beidseitig eingespannte Balken als auch einseitig eingespannte Balken nach oben verformt werden, wenn die resultierende Druckspannung der anderen Schichten durch die Druckspannung der unteren SiO₂-Schicht 28 übertroffen wird. Vorzugsweise wird die Schichtverbundstruktur in einem Winkel von näherungsweise 45° geätzt, so daß das Volumen der unteren SiO₂-Schicht 28 größer ist als das Volumen der oberen SiO₂-Schicht 36. Dadurch ist das Volumen der unteren Passivierungsschicht 28 bedingt durch den Ätzvorgang größer als das Volumen der oberen Passivierungsschicht 36, wodurch die durch die untere Passivierungsschicht 28 bewirkte Druckspannung größer ist als die durch die obere Passivierungsschicht 36 bewirkte Druckspannung.

Durch eine Veränderung der Streifenbreite der Einzelbalken einer Balkenstruktur kann die Vorauslenkung der Balken variiert werden. Da bei kleinen Streifen das Volumenverhältnis der oberen SiO₂-Schicht 36 zur unteren SiO₂-Schicht 28 klein ist, wird die Struktur stärker ausgelenkt. Bei breiteren Streifen verringert sich die Vorauslenkung.

Durch eine eingeprägte Zugspannung der Haftschichten und der Metallschicht kann die Auslenkung des Balkens nach oben unterstützt werden.

In Fig. 9b sind die Spannungszustände in dem in Fig. 9a gezeigten Schichtverbund dargestellt. Wie dargestellt ist, ist die durch die untere Passivierungsschicht 28 bewirkte Druckspannung größer als die durch die obere Passivierungsschicht 36 bewirkte Druckspannung. Durch das nicht-vertikale Ätzen der Einzelbalken und die Einstellung der Breite der Einzelbalken kann somit eine definierte Vorauslenkung der Balkenstruktur erreicht werden. Alternativ kann eine solche Vorauslenkung erreicht werden, indem die untere Passivierungsschicht dicker gemacht wird als die obere Passivierungsschicht, so daß wiederum die Druckspannung der unteren Schicht größer ist als die Druckspannung der oberen Schicht.

Wie bereits bezugnehmend auf Fig. 2 beschrieben wurde, ist der Kontaktbügel vorzugsweise mit einer Kompensationsschicht beschichtet. Der Kontaktbügel schließt und öffnet die Strompfade, weshalb es nötig ist, den Kontaktwiderstand zwischen dem Kontaktbügel und den zu kontaktierenden Anschlußflächen so gering wie möglich zu halten. Um dies zu erreichen, muß eine möglichst große Kontaktfläche zwischen dem Kontaktbügel und den Anschlußflächen sichergestellt sein. Da das Schichtmaterial des Kontaktbügels mit einer Zugspannung behaftet ist, kommt es zu einer Vorauslenkung des Kontaktbügels nach oben. Um diese Verformung zu kompensieren, wird die Kompensationsschicht mit einer inversen Eigenspannung, also mit einer Druckspannung, aufgebracht. Die Eigenspannung der Kompensationsschicht muß so groß sein, daß sie die Zugspannung des Kontaktbügels übertrifft, denn nur dann wird das bewegliche Kontaktstück nach unten verformt. Wie beschrieben, ist es notwendig, daß sich die zwei Enden des Kontaktbügels wieder nach oben verwölben, um zwischen den festen Anschlußflächen und den beweglichen Kontaktbügel eine optimale Kontaktfläche zu erhalten. Dies wird erreicht, indem die Kompensationsschicht nicht über die volle Länge des Kontaktbügels aufgetragen wird, sondern nur bis zu der Stelle, an der sich der Kontaktbügel wieder nach oben verwölben soll, also vorteilhafterweise etwa in der Mitte der Anschlußflächen. An dieser Stelle verliert die Kompensationsschicht ihre Wirkung und die resultierende Eigenspannung des Materials aus dem der Kontaktbügel gebildet ist, wirkt wieder auf die Struktur, so daß sich dieselbe an dieser Stelle wieder nach oben verformt, wie in Fig. 2 dargestellt ist.

In den Fig. 10a und 10b sind Seitenschnittansichten des Schichtaufbaus vor und nach dem Entfernen der Opferschicht dargestellt, die zur Veranschaulichung eines zweiten bevorzugten Ausführungsbeispiels der vorliegenden Erfindung dienen. Das zweite bevorzugte Ausführungsbeispiel unterscheidet sich von dem ersten bevorzugten Ausführungsbeispiel im wesentlichen durch die Bildung des Verankerungsbereichs der Balkenstruktur an dem Substrat. Die oben beschriebenen Ausbildungen der Balkenstruktur und die beschriebenen Verfahren zum Ätzen der Opferschicht sind auch für das zweite Ausführungsbeispiel anwendbar.

Als Basismaterial dient wiederum ein Substrat 100, das bei diesem Ausführungsbeispiel ebenfalls ein Siliziumwafer ist. Bei diesem Ausführungsbeispiel ist das Substrat 100 dotiert, um eine feststehende Elektrode zu definieren. Dazu kann das Substrat ganzflächig oder partiell dotiert sein. Auf das Substrat 100 wird nachfolgend eine Isolationsschicht 12, beispielsweise SiO₂ aufgebracht.

Nachfolgend wird auf die nun vorliegende Struktur eine Opferschicht oder Distanzschicht 126 aufgebracht, die bei diesem Ausführungsbeispiel ebenfalls aus Polyimid besteht. Diese Opferschicht 126 wird nun jedoch nicht photolithographisch strukturiert, sondern bleibt als geschlossene ebene Schicht stehen.

Auf diese Opferschicht 126 wird nun bei diesem Ausführungsbeispiel der bezugnehmend auf das erste Ausführungsbeispiel beschriebene Schichtverbund aufgebracht. Der Schichtverbund wird dann, beispielsweise photolithographisch, strukturiert, um die Balkenstruktur und ferner die beiden durch das Relais zu schließenden Kontakte, von denen nur einer, Kontakt 144, in den Fig. 10a und 10b gezeigt ist, festzulegen. Bei oder nach dieser Strukturierung wird die obere Passivierungsschicht und die obere Haftschicht von den Kontakten entfernt. Nachfolgend wird mittels photolithographischer Verfahren, beispielsweise unter Verwendung einer Maske 130, an dem später beweglichen Ende der Balkenstruktur isoliert von derselben ein Kontaktbereich in der Form eines Kontaktbügels 140 gebildet, wobei an der Unterseite des Kontaktbügels zumindest partiell wiederum eine Haftschicht 142 angeordnet sein kann.

Im Anschluß wird die Maske 130 entfernt und die Opferschicht wird geätzt, derart, daß Teile der Opferschicht als Verankerungsbereich 150 für die bewegliche Gegenelektrode 139 und als Trägerbereiche 152 für die Kontakte, von denen nur einer, 144, in den Fig. 10a und lOb dargestellt ist, stehen bleiben. Das Stehenbleiben des Verankerungsbereichs 150 und der Trägerbereiche 152 für die Kontakte wird durch ein zeitlich begrenztes Ätzen bewirkt, durch das die Balkenstruktur zwar freistehend wird, jedoch im Verankerungsbereich noch soviel Polyimid stehen bleibt, daß dieses als Verankerungsschicht dienen kann.

Es ist offensichtlich, daß die Kontakte auch bei diesem Ausführungsbeispiel vor dem Aufbringen der Opferschicht in oder auf dem Substrat gebildet werden könnten und dann mit Kontakthöckern versehen werden könnten.

Die vorliegende Erfindung schafft somit ein Verfahren zum Herstellen eines mikromechanischen Relais, das ausschließlich einen oberflächenmikromechanischen Prozeß verwendet, so daß der Flächenverbrauch pro Bauteil wesentlich verringert ist. Ferner entfällt gemäß der vorliegenden Erfindung das bei bekannten Herstellungsverfahren verwendete Chipbonden.

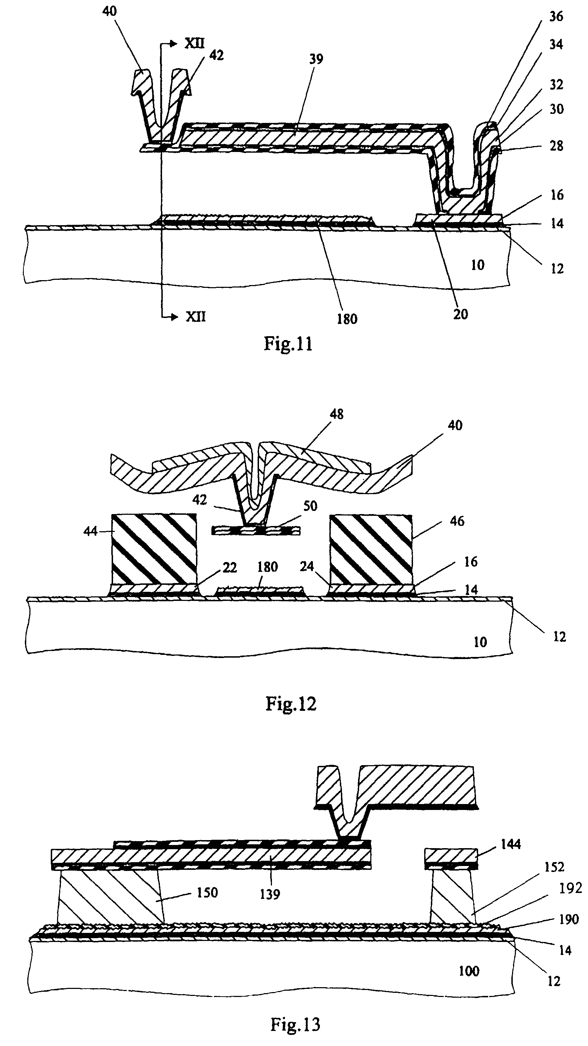

Bezugnehmend auf die Fig. 11 - 19 werden nachfolgend weitere Ausführungsbeispiele von mikromechanischen Relais, die mittels des erfindungsgemäßen Verfahrens hergestellt sind, erläutert. In den Fig. 11 - 19 sind für Elemente, die denen der Fig. 1 - 10 entsprechen, gleiche Bezugszeichen verwendet, wobei diese Elemente im folgenden nicht mehr erläutert werden.

Wie oben erwähnt wurde, besteht die Aufgabe der vorliegenden Erfindung darin, ein dauerhaftes Anhaften einer beweglichen Elektrode eines mikromechanischen Relais an der festen Elektrode im Betrieb des mikromechanischen Relais zuverlässig zu verhindern. Dazu müssen die Adhäsionskräfte zwischen der Struktur, d.h. der beweglichen Elektrode, und dem Substrat, d.h. der festen Elektrode, verringert werden. Dies kann erreicht werden, indem die Berührfläche zwischen den beiden Strukturen reduziert wird.

Eine Möglichkeit dies zu erreichen, ist in den Fig. 11 - 13 dargestellt. Um die Berührfläche zwischen der aufliegenden beweglichen Struktur, d.h. beispielsweise der Elektrode 39 in Fig. 11, und dem Substrat, d.h. der festen Elektrode 180 in den Fig. 11 und 12, zu vermindern, wird gemäß diesem Ausführungsbeispiel des erfindungsgemäßen Verfahrens eine galvanisch abgeschiedene feste Elektrode 180 verwendet. Diese als feste Elektrode verwendete galvanische Abscheidung kann entweder als feste Elektrode 180 strukturiert sein, siehe Fig. 11 und 12, oder ganzflächig abgeschieden sein, siehe Elektrode 190 in Fig. 13. Vorzugsweise wird hierbei eine Goldschicht galvanisch abgeschieden. Nachfolgend wird die Galvanik-Schicht angeätzt, um eine Rauhigkeit auf der Oberfläche derselben zu erreichen. Dadurch ergibt sich aufgrund der Topographie der Oberfläche eine verringerte Auflagefläche, d.h. eine verringerte Berührungsfläche zwischen der beweglichen Elektrode und der festen Elektrode. Mittels dieses Verfahrens ist allerdings nur eine begrenzte Reduzierung der Berührfläche möglich.

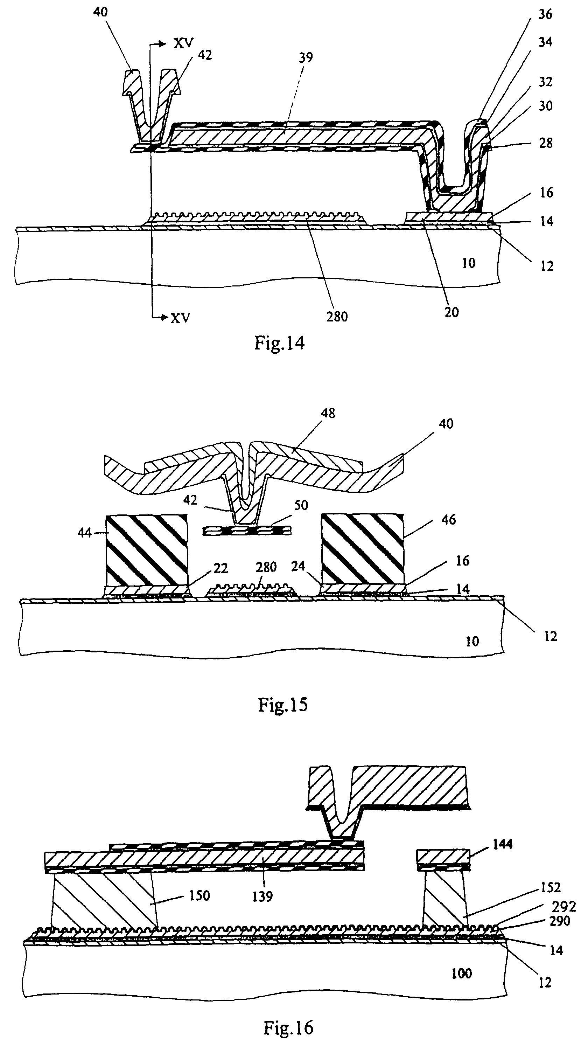

Ein zweites Verfahren, das zu einer erfindungsgemäßen Verringerung der Berührfläche führt, wird nachfolgend bezugnehmend auf die Fig. 14 - 16 erläutert. Bei diesem Ausführungsbeispiel wird eine Galvanik-Schicht, die vorzugsweise als feste Elektrode dient, derart strukturiert, daß Erhebungen entstehen. Diese Erhebungen und Vertiefungen werden mittels eines naßchemischen Prozesses oder mittels eines Trockenätzprozesses bewirkt. Dabei ist die Phototechnik derart ausgelegt, daß in regelmäßigen Abständen Erhebungen erzeugt werden, auf denen die bewegliche Elektrode im ausgelenkten Zustand aufliegt. Wiederum kann die feste Elektrode ganzflächig auf dem Substrat aufliegen, siehe Elektrode 290 in Fig. 16 oder auf dem Substrat strukturiert sein, siehe Elektrode 280 in den Fig. 14 und 15. Durch diese Erzeugung von Vertiefungen und Erhebungen wird eine erhebliche Reduzierung der Berührflächen möglich, wobei diese Anti-Anhaft-Erhebungen sehr stumpf sind und ferner die Dimension der Erhebungen an das Auflösungsvermögen der Phototechnik gebunden ist.

In den Fig. 13 und 16 ist ferner eine dünne Haftschicht 192, 292 zwischen der Galvanik-Goldschicht 190 bzw. 290 und dem Träger 152, der beispielsweise aus Polyimid besteht, dargestellt. Diese Haftschicht 192 bzw. 292 dient dazu, die Haftung zwischen der Goldschicht und dem Polyimidträger zu verbessern. Diese Haftschicht besteht beispielsweise aus Ti. Da eine solche Haftschicht sehr dünn ist und die Oberflächenstruktur durch das Sputterverfahren, durch das die Haftschicht aufgebracht wird, konform abgebildet wird, bleibt die Oberflächenrauhigkeit, die die verringerte Berührungsfläche zur Folge hat, erhalten.

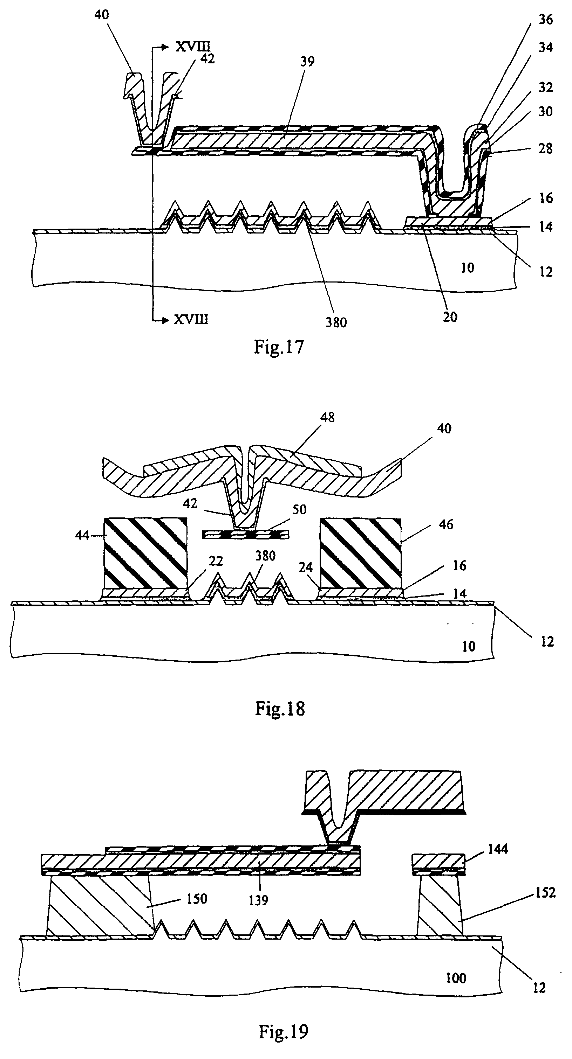

Anhand der Fig. 17 - 19 wird nun ein weiteres Ausführungsbeispiel, wie erfindungsgemäß eine Verringerung der Berührfläche erreicht werden kann, dargelegt. Um bei diesem Ausführungsbeispiel Elektroden mit der gewünschten Oberflächenbeschaffenheit zu schaffen, werden in einen einkristallinen Siliziumwaver naßchemisch Pyramiden geätzt. Bei der Herstellung dieser Pyramiden werden die unterschiedlichen Kristallrichtungen des Siliziums ausgenutzt, die unterschiedliche Ätzraten aufweisen. Mittels dieses Verfahrens lassen sich Pyramiden mit einer ausgezeichneten Spitzigkeit herstellen. Somit läßt sich eine drastische Reduzierung der Berührflächen und somit der Adhäsionskräfte bewirken. Allerdings ist man an die Verwendung von Silizium als dem Substratmaterial gebunden. Die Elektrode mit der gewünschten Oberflächenbeschaffenheit kann nun auf die in dem Substrat gebildeten Spitzen aufgebracht sein, siehe Elektrode 380 in den Fig. 17 und 18 oder kann alternativ in demselben angeordnet sein, siehe Fig. 19.

Der Abstand und die Abmessungen der Erhebungen und Vertiefungen in der erfindungsgemäß behandelten Oberfläche der festen Elektrode ist variabel und kann jeweils an die Prozesstechnologie angepaßt werden. In gleicher Weise ist die Höhe der Erhebungen variabel.

## Patentansprüche

1. Verfahren zum Herstellen eines mikromechanischen Relais mit folgenden Schritten:
a) Bereitstellen eines Substrats (10; 100) mit einer leitfähigen festen Elektrode (18; 180; 190; 280; 290; 380) in dem Substrat (10; 100) oder auf demselben;
b) Aufbringen einer Opferschicht (26; 126);
c) Aufbringen einer leitfähigen Schicht (32) und Strukturieren der leitfähigen Schicht (32) zur Festlegung einer Balkenstruktur als bewegliche Gegenelektrode (39; 139) gegenüber der festen Elektrode (18), und Aufbringen eines Kontaktbereichs (40; 140), wobei sich die leitfähige Schicht (32) zwischen einem Verankerungsbereich (54; 62; 150) und dem Kontaktbereich (40; 140) erstreckt und gegenüber dem Kontaktbereich (40; 140) isoliert ist; und
d) Entfernen der Opferschicht (26; 126) mittels Ätzen, um die Balkenstruktur mit einem beweglichen Bereich und einem an dem Verankerungsbereich (54, 62; 150) an dem Substrat (10; 100) befestigten Bereich zu erzeugen,
dadurch gekennzeichnet,
daß die Balkenstruktur derart festgelegt wird, daß Ätzzugangsöffnungen in derselben derart strukturiert sind, daß die flächenmäßige Ausdehnung der Ätzzugangsöffnungen (66; 70) zum Ätzen der Opferschicht (26: 126) von dem an dem Substrat (10; 100) befestigen Bereich der Balkenstruktur (54, 62) zu dem beweglichen Bereich der Balkenstruktur hin zunimmt, so daß das Ätzen der Opferschicht (26; 126) derart gesteuert wird, daß der unter dem beweglichen Bereich der Balkenstruktur angeordnete Abschnitt der Opferschicht (26; 126) schneller geätzt wird als der im Bereich des Verankerungsbereichs (54; 62; 150) angeordnete Abschnitt der Opferschicht (26; 126).

2. Verfahren gemäß Anspruch 1, bei dem vor dem Schritt b) zwei Kontakte (22, 24) in oder auf dem Substrat (10) gebildet werden, wobei sich der im Schritt c) gebildete Kontaktbereich (40) zumindest zwischen den Kontakten (22, 24) und über denselben durch die Opferschicht (26) beabstandet von denselben erstreckt.

3. Verfahren gemäß Anspruch 1 oder 2, bei dem die Opferschicht (26) nach dem Aufbringen derselben strukturiert wird, um den Verankerungsbereich (54; 62) der Balkenstruktur gegenüber dem Substrat (10) festzulegen.

4. Verfahren gemäß Anspruch 2 oder 3, bei dem eine Metallschicht (16) ganzflächig auf dem Substrat abgeschieden wird und zur Festlegung der festen Elektrode (18) und der Kontakte (22, 24) photolithographisch strukturiert wird.

5. Verfahren gemäß einem der Ansprüche 1 bis 4, bei dem im Bereich des Verankerungsbereichs (54; 62) der Balkenstruktur vor dem Schritt b) eine Verankerungskontaktfläche (20) erzeugt wird.

6. Verfahren gemäß Anspruch 1, bei dem im Schritt d) die Opferschicht (126) derart geätzt wird, daß ein Teil der Opferschicht (150) stehen bleibt, um eine Verankerungsschicht für den feststehenden Teil der Balkenstruktur für eine Verankerung an dem Substrat (100) zu bilden.

7. Verfahren gemäß Anspruch 6, bei dem im Schritt c) aus der leitfähigen Struktur ferner zwei auf der Opferschicht angeordnete Kontakte (144) strukturiert werden, wobei die Opferschicht im Schritt d) derart geätzt wird, daß ferner zwei Trägerbereiche (152) der Opferschicht (126) auf dem Substrat verbleiben, auf denen die Kontakte (144) angeordnet sind.

8. Verfahren gemäß einem der Ansprüche 1 bis 7, bei dem die Opferschicht (26) mittels Trockenätzen entfernt wird.

9. Verfahren gemäß Anspruch 8, bei dem die Opferschicht (26) aus Polyimid besteht.

10. Verfahren gemäß einem der Ansprüche 1 bis 9, bei dem im Schritt c) vor und nach dem Aufbringen der leitfähigen Schicht (32) eine Passivierungsschicht (28, 36) aufgebracht wird, derart, daß die leitfähige Schicht (32) zwischen zwei Passivierungsschichten (28, 36) angeordnet ist.

11. Verfahren gemäß Anspruch 10, bei dem die leitfähige Schicht (32) aus Gold besteht und die zwei Passivierungsschichten (28, 36) aus SiO₂ bestehen.

12. Verfahren gemäß Anspruch 10 oder 11, bei dem die leitfähige Schicht (32) und die Passivierungsschichten (28, 36) derart strukturiert werden, daß die unter der leitfähigen Schicht (32) angeordnete Passivierungsschicht (28) eine größere Druckspannung aufweist als die über der leitfähigen Schicht (32) angeordnete Passivierungsschicht (36), um eine Auslenkung des beweglichen Bereichs der Balkenstruktur von dem Substrat (10; 100) weg zu bewirken, wenn die Opferschicht (26; 126) entfernt ist.

13. Verfahren gemäß Anspruch 12, bei dem die leitfähige Schicht (32) und die Passivierungsschichten (28, 36) derart strukturiert werden, daß nach dem Strukturieren das Volumen der unter der leitfähigen Schicht (32) angeordneten Passivierungsschicht (28) größer ist als das Volumen der über der leitfähigen Schicht (32) angeordneten Passivierungsschicht (36).

14. Verfahren gemäß einem der Ansprüche 10 bis 13, bei dem die über der leitfähigen Schicht (32) aufgebrachte Passivierungsschicht (36) dünner ist als die unter der leitfähigen Schicht (32) aufgebrachte Passivierungsschicht (28).

15. Verfahren gemäß einem der Ansprüche 1 bis 14, bei dem die Balkenstruktur aus einem einzelnen Balken (68; 72) besteht, in dem Ätzzugangsöffnungen (66; 70) zum Ätzen der Opferschicht (26; 126) strukturiert sind.

16. Verfahren gemäß einem der Ansprüche 1 bis 14, bei dem die Balkenstruktur aus einer Mehrzahl nebeneinander angeordneter Einzelbalken (52; 56, 58; 64) besteht.

17. Verfahren gemäß Anspruch 16, bei dem das Maß der Auslenkung des beweglichen Bereichs der Balkenstruktur durch das Einstellen der Breite der einzelnen Balken (52; 56, 58; 64) gesteuert wird.

18. Verfahren gemäß Anspruch 16, bei dem die Einzelbalken (64) der Balkenstruktur zum beweglichen Bereich derselben hin schmaler werdend, keilförmig strukturiert werden.

19. Verfahren gemäß einem der Ansprüche 1 bis 18, bei dem der Kontaktbereich (40; 140) in der Form eines quer zu der Balkenstruktur verlaufenden Kontaktbügels aufgebracht wird, der isoliert von der leitfähigen Schicht (32) der Balkenstruktur im beweglichen Bereich derselben an derselben angebracht ist.

20. Verfahren gemäß Anspruch 19, bei dem der Kontaktbügel (40; 140) auf der Oberseite desselben in dem Bereich, der sich zwischen den Kontakten (22, 24) erstreckt, mit einer Kompensationsschicht (48) versehen ist, die eine Eigendruckspannung aufweist, die eine Eigenzugspannung des Kontaktbügels (40; 140) kompensiert.

21. Verfahren gemäß einem der Ansprüche 1 bis 20, bei dem der Kontaktbereich aus Gold besteht.

22. Verfahren gemäß Anspruch 21, bei dem die Kompensationsschicht aus TiW besteht.

23. Verfahren gemäß Anspruch 3, bei dem die Opferschicht (26) derart photolithographisch strukturiert wird, daß der Verankerungsbereich aus zwei Verankerungsteilbereichen (60, 62) besteht, derart, daß die Balkenstruktur an beiden Enden derselben den an dem Substrat befestigten Bereich aufweist und im mittleren Bereich den beweglichen Bereich aufweist.

24. Verfahren gemäß Anspruch 6, bei dem die Opferschicht derart geätzt wird, daß die Verankerungsschicht zwei Verankerungsteilbereiche definiert, derart, daß die Balkenstruktur an beiden Enden derselben den an dem Substrat befestigten Bereich aufweist und im mittleren Bereich den beweglichen Bereich aufweist.

25. Verfahren gemäß einem der Ansprüche 1 bis 24, bei dem die leitfähige feste Elektrode (180; 190; 280; 290; 380) bei dem Schritt a) mit einer solchen Oberflächenbeschaffenheit ausgebildet wird, daß beim späteren Betrieb des mikromechanischen Relais eine Berührungsfläche der festen Elektrode (180; 190; 280; 290; 380) mit der beweglichen Gegenelektrode (39; 139) gegenüber der Berührungsfläche einer im wesentlichen flachen Oberfläche der festen Elektrode reduziert ist.

26. Verfahren gemäß Anspruch 25, bei dem die leitfähige feste Elektrode (180; 190) durch eine galvanische Abscheidung erzeugt wird und nachfolgend zur Aufrauhung der Oberfläche derselben angeätzt wird.

27. Verfahren gemäß Anspruch 25, bei dem die leitfähige feste Elektrode (280; 290) durch das galvanische Abscheiden einer Schicht erzeugt wird, wobei die Schicht nachfolgend strukturiert wird, um Erhebungen und Vertiefungen in derselben zu bilden.

28. Verfahren gemäß Anspruch 25, bei dem als Substrat (10; 100) ein einkristallines Silizium verwendet wird, in dessen Oberflächenbereich, in oder auf dem die feste Elektrode (380) gebildet wird, naßchemisch pyramidenförmige Strukturen geätzt werden.

## Claims

1. A method of producing a micromechanical relay comprising the following steps:
a) providing a substrate (10; 100) including a conductive fixed electrode (18; 180; 190; 280; 290; 380) in or on said substrate (10; 100);
b) applying a sacrificial layer (26; 126);
c) applying a conductive layer (32) and structuring said conductive layer (32) so as to define a beam structure as a movable counterelectrode (39; 139) opposite said fixed electrode (18), and applying a contact area (40; 140), the conductive layer (32) extending between an anchoring region (54; 62; 150) and the contact area (40; 140) and being insulated from said contact area (40; 140); and
d) removing the sacrificial layer (26; 126) by means of etching so as to produce the beam structure comprising a movable area and an area secured to the anchoring region (54, 62; 150) on the substrate (10; 100),
characterized in that
the beam structure is defined such that etch access openings in said beam structure are structured such that the size of the area covered by the etch access openings (66; 70) used for etching the sacrificial layer (26; 126) increases from the area of the beam structure (54, 62) secured to the substrate (10; 100) to the movable area of the beam structure so that the etching of the sacrificial layer (26; 126) is controlled in such a way that the portion of the sacrificial layer (26; 126) arranged below the movable area of the beam structure is etched faster than the portion of the sacrificial layer (26; 126) arranged in the area of the anchoring region (54; 62; 150).

2. A method according to claim 1, wherein, prior to step b), two contacts (22, 24) are formed in or on the substrate (10), the contact area (40) formed in step c) extending at least between said contacts (22, 24) and over them, said contact area (40) being spaced from said contacts (22, 24) by the sacrificial layer (26).

3. A method according to claim 1 or 2, wherein the sacrificial layer (26) is structured after its application so as to define the anchoring region (54; 62) of the beam structure relative to the substrate (10).

4. A method according to claim 2 or 3, wherein a metal layer (16) is deposited on the substrate over the full area and wherein photolithographic structuring is carried out so as to define the fixed electrode (18) and the contacts (22, 24).

5. A method according to one of the claims 1 to 4, wherein, prior to step b), an anchoring contact surface (20) is produced in the area of the anchoring region (54; 62) of the beam structure.

6. A method according to claim 1, wherein the sacrificial layer (126) is etched in step d) in such a way that a part (150) of said sacrificial layer remains so as to form an anchoring layer for the fixed part of the beam structure for anchoring to the substrate (100).

7. A method according to claim 6, wherein, in step c), two contacts (144) arranged on the sacrificial layer are additionally formed by structuring the conductive structure, the sacrificial layer being etched in step d) in such a way that also two support areas (152) of the sacrificial layer (126) remain on the substrate, the contacts (144) being arranged on said support areas (152).

8. A method according to one of the claims 1 to 7, wherein the sacrificial layer (26) is removed by means of dry etching.

9. A method according to claim 8, wherein the sacrificial layer (26) consists of polyimide.

10. A method according to one of the claims 1 to 9, wherein, in step c), a passivation layer (28, 36) is applied prior to and after the application of the conductive layer (32), said passivation layers being applied such that the conductive layer (32) is arranged between two passivation layers (28, 36).

11. A method according to claim 10, wherein the conductive layer (32) consists of gold and the two passivation layers (28, 36) consist of SiO₂.

12. A method according to claim 10 or 11, wherein the conductive layer (32) and the passivation layers (28, 36) are structured such that the compressive stress of the passivation layer (28), which is arranged below the conductive layer (32), exceeds the compressive stress of the passivation layer (36), which is arranged above the conductive layer (32), so as to cause the movable area of the beam structure to be deflected away from the substrate (10; 100) when the sacrificial layer (26; 126) has been removed.

13. A method according to claim 12, wherein the conductive layer (32) and the passivation layers (28, 36) are structured such that, after the structuring, the volume of the passivation layer (28) arranged below the conductive layer (32) is larger than the volume of the passivation layer (36) arranged above the conductive layer (32).

14. A method according to one of the claims 10 to 13, wherein the passivation layer (36) applied on top of the conductive layer (32) is thinner than the passivation layer (28) applied below the conductive layer (32).

15. A method according to one of the claims 1 to 14, wherein the beam structure consists of a single beam (68; 72) having provided therein etch access openings (66; 70) by means of structuring, said etch access openings (66; 70) being used for etching the sacrificial layer (26; 126).

16. A method according to one of the claims 1 to 14, wherein the beam structure consists of a plurality of juxtaposed individual beams (52; 56, 58; 64).

17. A method according to claim 16, wherein the extent to which the movable area of the beam structure is deflected is controlled by adjusting the width of the individual beams (52; 56, 58; 64).

18. A method according to claim 16, wherein the individual beams (64) of the beam structure are structured such that they taper towards the movable area of the beam structure in a wedge-shaped configuration.

19. A method according to one of the claims 1 to 18, wherein the contact area (40; 140) is applied in the form of a contact bridge extending transversely to the beam structure, said contact bridge being insulated from the conductive layer (32) of the beam structure and being attached to said beam structure in the movable area thereof.

20. A method according to claim 19, wherein said contact bridge (40; 140) is provided with a compensation layer (48), which is applied to the upper side of said contact bridge in the area extending between the contacts (22, 24) and in which an self-contained compressive stress exists by means of which an self-contained tensile stress of the contact bridge (40; 140) is compensated.

21. A method according to one of the claims 1 to 20, wherein the contact area consists of gold.

22. A method according to claim 21, wherein the compensation layer consists of TiW.

23. A method according to claim 3, wherein the sacrificial layer (26) is photolithographically structured such that the anchoring region comprises two anchoring subregions (60, 62) in such a way that the beam structure has at both ends thereof the areas secured to the substrate, whereas the movable area is located in the central region thereof.

24. A method according to claim 6, wherein the sacrificial layer is etched in such a way that the anchoring layer defines two anchoring subregions in such a way that the beam structure has at both ends thereof the areas secured to the substrate, whereas the movable area is located in the central region thereof.

25. A method according to one of the claims 1 to 24, wherein the conductive fixed electrode (180; 190; 280; 290; 380) is implemented in step a) with surface properties of such a nature that, during the future operation of the micromechanical relay, a contact surface of the fixed electrode (180; 190; 280; 290; 380) with the movable counterelectrode (39; 139) will be reduced in comparison with the contact surface of an essentially flat surface of the fixed electrode.

26. A method according to claim 25, wherein the conductive fixed electrode (180; 190) is produced by electrodeposition and is then pre-etched so as to roughen the surface thereof.

27. A method according to claim 25, wherein the conductive electrode (280; 290) is produced by electrodepositing a layer, said layer being then structured so as to form elevations and depressions therein.

28. A method according to claim 25, wherein a monocrystalline silicon is used as a substrate (10; 100), pyramidal structures being etched in a wet-chemical process into the surface area of said monocrystalline silicon in or on which the fixed electrode (380) is formed.

## Revendications

1. Procédé de production d'un relais micromécanique, aux étapes suivantes consistant à :
a) préparer un substrat (10; 100) avec une électrode conductrice fixe (18; 180; 190; 280; 290; 380) dans le substrat (10; 100) ou sur celui-ci;
b) appliquer une couche de sacrifice (26; 126);
c) appliquer une couche conductrice (32) et structurer la couche conductrice (32) en vue de déterminer une structure de poutre en tant que contre-électrode mobile (39; 139) par rapport à l'électrode fixe (18), et appliquer une zone de contact (40; 140), la couche conductrice (32) s'étendant entre une zone d'ancrage (54; 62; 150) et la zone de contact (40; 140) et étant isolée par rapport à la zone de contact (40; 140); et
d) éliminer la couche de sacrifice (26; 126) par décapage, afin de produire la structure de poutre avec une zone mobile et une zone fixée, à la zone d'ancrage (54, 62; 150), au substrat (10; 100),
caractérisé par le fait que la structure de poutre est déterminée de telle sorte que des ouvertures d'accès de décapage dans celle-ci sont structurées de telle sorte que l'extension en superficie des ouvertures d'accès de décapage (66; 70) destinées au décapage de la couche de sacrifice (26; 126) augmente de la zone de la structure de poutre (54, 62) fixée au substrat (10; 100) vers la zone mobile de la structure de poutre, de sorte que le décapage de la couche de sacrifice (26; 126) puisse être réglé de telle sorte que le segment de la couche de sacrifice (26; 126) disposée sous la zone mobile de la structure de poutre (26; 126) est décapée plus rapidement que le segment de la structure de poutre (26; 126) disposé à l'endroit de la zone d'ancrage (54; 62; 150).

2. Procédé suivant la revendication 1, dans lequel, avant l'étape b), deux contacts (22, 24) sont formés dans ou sur le substrat (10), la zone de contact (40) formée à l'étape c) s'étendant, au moins entre les contacts (22, 24) et au-dessus de ces derniers, distants de ceux-ci, grâce à la couche de sacrifice (26).

3. Procédé suivant la revendication 1 ou 2, dans lequel la couche de sacrifice (26) est, après l'application de celle-ci, structurée en vue de déterminer la zone d'ancrage (54; 62) de la structure de poutre par rapport au substrat (10).

4. Procédé suivant la revendication 2 ou 3, dans lequel une couche métallique (16) est déposée sur toute la surface sur le substrat et est structurée photolithographiquement en vue de déterminer l'électrode fixe (18) et les contacts (22, 24).

5. Procédé suivant l'une des revendications 1 à 4, dans lequel est produite, à l'endroit de la zone d'ancrage (54; 62) de la structure de poutre, avant l'étape b), une face de contact d'ancrage (20).

6. Procédé suivant la revendication 1, dans lequel, à l'étape d), la couche de sacrifice (126) est décapée de telle sorte qu'il reste une partie de la couche de sacrifice (150), pour constituer une couche d'ancrage de la partie fixe de la structure de poutre, en vue d'un ancrage au substrat (100).

7. Procédé suivant la revendication 6, dans lequel, à l'étape d), sont par ailleurs structurés, dans la structure conductrice, deux contacts (144) disposés sur la couche de sacrifice, la couche de sacrifice étant décapée, à l'étape d), de telle sorte qu'il reste, par ailleurs, deux zones de support (152) de la couche de sacrifice (126) sur le substrat, sur lesquelles sont disposés les contacts (144).

8. Procédé suivant l'une des revendications 1 à 7, dans lequel la couche de sacrifice (26) est éliminée par décapage à sec.

9. Procédé suivant la revendication 8, dans lequel la couche de sacrifice (26) est réalisée en polyimide.

10. Procédé suivant l'une des revendications 1 à 9, dans lequel, à l'étape c), il est, avant et après l'application de la couche conductrice (32), appliqué une couche de passivation (28, 36), de sorte que la couche conductrice (32) soit disposée entre les deux couches de passivation (28, 36).

11. Procédé suivant la revendication 10, dans lequel la couche conductrice (32) est en or et les deux couches de passivation (28, 36) sont en SiO2.

12. Procédé suivant la revendication 10 ou 11, dans lequel la couche conductrice (32) et les deux couches de passivation (28, 36) sont structurées de telle sorte que la couche de passivation (28) disposée sous la couche conductrice (32) présente un effort de compression supérieur à celui de la couche de passivation (36) disposée sur la couche conductrice (32), afin d'entraîner une déviation de la zone mobile de la structure de poutre en s'éloignant du substrat (10; 100) lorsque la couche de sacrifice (26; 126) est éliminée.

13. Procédé suivant la revendication 12, dans lequel la couche conductrice (32) et les couches de passivation (28, 36) sont structurées de telle sorte qu'après la structuration, le volume de la couche de passivation (28) disposée sous la couche conductrice (32) est supérieur au volume de la couche de passivation (36) disposée au-dessus de la couche conductrice (32).

14. Procédé suivant l'une des revendications 10 à 13, dans lequel la couche de passivation (36) appliquée sur la couche conductrice (32) est plus mince que la couche de passivation (28) appliquée sous la couche conductrice (32).

15. Procédé suivant l'une des revendications 1 à 14, dans lequel la structure de poutre se compose d'une seule poutre (68; 72) dans laquelle sont structurées des ouvertures d'accès de décapage (66; 70), pour le décapage de la couche de sacrifice (26; 126).

16. Procédé suivant l'une des revendications 1 à 14, dans lequel la structure de poutre se compose d'une pluralité de poutres individuelles (52; 56, 58; 64) disposées l'une à côté de l'autre.

17. Procédé suivant la revendication 16, dans lequel le degré de déviation de la zone mobile de la structure de poutre est réglé par réglage de la largeur des poutres individuelles (52; 56, 58; 64).

18. Procédé suivant la revendication 16, dans lequel les poutres individuelles (64) de la structure de poutre sont structurées de manière cunéiforme en s'effilant vers la zone mobile de cette dernière.

19. Procédé suivant l'une des revendications 1 à 18, dans lequel la zone de contact (40 ; 140) est appliquée sous forme d'un étrier de contact s'étendant transversalement à la structure de poutre, lequel est appliqué, de manière isolée de la couche conductrice (32) de la structure de poutre, dans la zone mobile de cette dernière, sur cette dernière.

20. Procédé suivant la revendication 19, dans lequel l'étrier de contact (40 ; 140) est pourvu, sur sa surface, dans la zone s'étendant entre les contacts (22, 24), d'une couche de compensation (48) présentant un effort de compression propre compensant un effort de traction propre de l'étrier de contact (40 ; 140).

21. Procédé suivant l'une des revendications 1 à 20, dans lequel la zone de contact est réalisée en or.

22. Procédé suivant la revendication 21, dans lequel la couche de compensation est en TiW.

23. Procédé suivant la revendication 3, dans lequel la couche de sacrifice (26) est structurée photolithographiquement de telle sorte que la zone d'ancrage se compose de deux zones d'ancrage partielles (60, 62), de telle sorte que la structure de poutre présente, aux deux extrémités de celle-ci, la zone fixée au substrat et présente, dans la partie centrale, la zone mobile.

24. Procédé suivant la revendication 6, dans lequel la couche de sacrifice est décapée de telle sorte que la couche d'ancrage définit deux zones d'ancrage partielles, de telle sorte que la structure de poutre présente, aux deux extrémités de celle-ci, la zone fixée au substrat et présente, dans la partie centrale, la zone mobile.

25. Procédé suivant l'une des revendications 1 à 24, dans lequel l'électrode conductrice fixe (180; 190; 280; 290; 380) est, à l'étape a), réalisée avec une qualité de surface telle que lors du fonctionnement ultérieur du relais micromécanique, une face de contact de l'électrode fixe (180; 190; 280; 290; 380) avec la contre-électrode mobile (39; 139) est réduite par rapport à la face de contact d'une surface sensiblement plane de l'électrode fixe.

26. Procédé suivant la revendication 25, dans lequel l'électrode conductrice fixe (180; 190) est générée par un dépôt galvanique et ensuite gravée en vue de rendre sa surface rugueuse.

27. Procédé suivant la revendication 25, dans lequel l'électrode conductrice fixe (280; 290) est générée par le dépôt galvanique d'une couche, la couche étant ensuite structurée afin de former des saillies et des creux dans celle-ci.

28. Procédé suivant la revendication 25, dans lequel on utilise, comme substrat (10; 100), un silicium monocristallin dans la zone superficielle duquel, dans ou sur laquelle est formée l'électrode fixe, sont gravées, par un procédé chimique humide, des structures pyramidales.
